# EUROPÄISCHE PATENTSCHRIFT

(11) **EP 1 845 765 B1**
(45) Veröffentlichungstag und Bekanntmachung des Hinweises auf die Patenterteilung: **20.01.2010**
(21) Anmeldenummer: 06008996.8
(22) Anmeldetag: 29.04.2006
(51) Int. Cl.: H05K 7/14

(54) **Baugruppenträger**
Rack
Baie électronique

(30) Priorität: 11.04.2006 DE 102006017329
(43) Veröffentlichungstag der Anmeldung: 17.10.2007
(73) Patentinhaber: Schroff GmbH, D-75334 Straubenhardt (DE)
(72) Erfinder: Joist, Michael, 76571 Gaggenau (DE); Weber, Rainer, 76307 Karlsbad (DE)
(74) Vertreter: Durm, Frank

(56) Entgegenhaltungen:
- DE-A1- 3 140 730
- DE-C1- 19 755 018
- DE-U1- 8 908 260

## Beschreibung

Die vorliegende Erfindung betrifft einen Baugruppenträger für elektronische Steckbaugruppen, die eine Leiterplatte, eine Frontplatte und einen Steckverbinder aufweisen, mit wenigstens einem Tragblech, das im Raster angeordnete, Befestigungsausnehmungen aufweist, mindestens einer Führungsschiene aus Kunststoff, die auf das Tragblech montierbar ist und eine nach oben offene Führungsnut aufweist, und mit einem im Bereich der vorderen Kante des Tragblechs angeordneten Verriegelungselement, das der Verriegelung der vollständig eingeschobenen Steckbaugruppe dient.

Bei modular aufgebauten elektronischen Geräten ist es heute üblich, die einzelnen Elektronikmodule als Steckbaugruppen auszuführen. Eine solche Steckbaugruppe weist an ihrem hinteren Ende einen vielpoligen Steckverbinder auf, der in eine korrespondierende Steckerleiste auf der Rückverdrahtungsplatte, der sog. Backplane, des Baugruppenträgers eingesteckt wird.

Vorliegend geht es speziell um Baugruppenträger für Steckbaugruppen, auch Module genannt, für moderne Telekommunikations-Systeme nach dem von der PICMG (PCI .Industrial Computer Manufacturers Group) entwickelten AMC-Standard (Advanced Mezzanine Card). Die dieser Spezifikation entsprechenden Steckbaugruppen sind relativ klein und haben eine an die Leiterplatte montierte Frontplatte. Passend zu den AMC-Modulen gibt es spezielle Baugruppenträger, deren Form und Abmessungen, in der PICMG-Spezifikation MicroTCA definiert sind. Ein solcher Baugruppenträger umfasst ein oberes und ein unteres Tragblech, die von zwei Seitenwänden im Abstand gehalten werden. Auf den Tragblechen sind Führungsschienen mit Führungsnuten für die Leiterplatten angeordnet. Diese Führungsschienen können durch Blechumformung in die Tragbleche integriert sein oder als modulare, frei positionierbare Führungsschienen aus Kunststoff ausgebildet sein.

Eine Besonderheit der MicroTCA-Baugruppenträger für AMC-Module ist der fehlende Tiefenanschlag für die Frontplatten der Steckbaugruppen. Der Tiefenanschlag erfolgt einfach über die hinterste Kante der Leiterplatte. Indes schreibt der AMC-Standard einen Verriegelungsmechanismus vor, bei dem ein Verriegelungshöcker auf dem Tragblech von einer Verriegelungszunge der Steckbaugruppe umgriffen wird. Die AMC-Spezifikation verlangt sehr kleine Abmessungen des Verriegelungshöckers.

Bekannt sind Tragbleche für MicroTCA mit aus dem Blech nach oben herausgebogenen Verriegelungshöckern. Diese haben den Vorteil, sehr stabil zu sein. Ein großer Nachteil ist aber, dass die Anordnung der Verriegelungshöcker nicht variabel ist, d.h. also, dass entweder für jede mögliche Position einer Führungsschiene auf dem Tragblech ein Verriegelungshöcker vorgesehen sein muss oder die Führungsschienen nur an einigen vorgegebenen Positionen auf dem Tragblech montiert werden können. Gemischte Konfigurationen mit Steckbaugruppen unterschiedlicher Breite sind damit praktisch nicht möglich.

Aus DE 89 08 260 U1 ist ein Baugruppenträger bekannt, der eine Leiterplatte, eine Frontplatte und einen Steckverbinder aufweist, mit einer Gehäusewand, die Ausnehmungen aufweist, und mit Führungsschienen, die auf die Gehäusewand montierbar sind und eine nach oben offene Führungsnut aufweisen. Das Frontteil der Führungsschiene weist eine schlitzförmige Einkerbung und frontseitig eine schräge Anlauffläche auf. Ein an der Leiterplatte angeordneter schwenkbarer Hebel hat ein Profil in der Art einer Hundeschnauze. Das schnauzenförmige Teil greift bei Betätigung des Hebels in die Einkerbung im vorderen Teil der Führungsschiene ein. Die Führungsschiene ist so konstruiert, dass sie einerseits als Führung für die Leiterplatte dient und andererseits die über den Hebel eingeleiteten Kräfte beim Steck- bzw. Ziehvorgang aufnimmt.

Aus DE 19755018 C1 ist ein Baugruppenträger mit führungsschienen und separaten Verriegelungselementen bekannt.

Für einen flexibel bestückbaren Baugruppenträger, der Steckbaugruppen mit unterschiedlich breiten Frontplatten aufnehmen kann, muss der Verriegelungshöcker individuell auf dem Tragblech positionierbar sein. Der an sich nahe liegende Weg, den Verriegelungshöcker an frei positionierbare Führungsschienen anzuformen, scheidet aus, weil das für solche Führungsschienen verwendete Kunststoffmaterial bei weitem nicht stabil genug ist, um der mechanischen Beanspruchung beim Verriegeln einer Steckbaugruppe standzuhalten.

Es stellt sich somit das technische Problem, einen Baugruppenträger der eingangs beschriebenen Art mit frei positionierbaren, belastbaren Verriegelungselementen, insbesondere Verriegelungshöckern nach AMC-Standard, zu versehen, wobei die Montage der Verriegelungselemente möglichst einfach und komfortabel sein soll.

Bei der Lösung der gestellten Aufgabe wird ausgegangen von einem Baugruppenträger für elektronische Steckbaugruppen gemäß dem Oberbegriff des Patentanspruchs 1. Gelöst wird die Aufgabe gemäß dem kennzeichnenden Teil des Patentanspruchs 1 durch einen speziellen Lagerblock, der an der Führungsschiene gelagert ist, einen in ein Formloch des Tragblechs formschlüssig einsetzbaren Lagerzapfen hat und das benötigte bzw. vorgeschriebene Verriegelungselement trägt.

Erfindungsgemäß ist das Verriegelungselement weder integraler Bestandteil des Tragblechs noch etwa an der Führungsschiene angeformt, sondern ist auf einem separaten Lagerblock angeordnet. Die normgerechte Positionierung des Verriegelungselements und die stabile Verankerung des Lagerblocks werden dadurch gewährleistet, dass der Lagerblock sowohl an der Führungsschiene gelagert ist als auch mittels seines Lagerzapfens formschlüssig in ein Formloch des Tragblechs eingesetzt wird. Durch die Ankopplung des Lagerblocks an die Führungsschiene wird es möglich, die Führungsschiene mit einem vormontierten Lagerblock auszurüsten. Die Montage des Lagerblocks kann dann in einem Zug zusammen mit der Befestigung der Führungsschiene auf dem Tragblech erfolgen.

Das ist sehr komfortabel für den Benutzer. Gleichzeitig wird eine korrekte Positionierung des Verriegelungselements in Bezug auf die Führungsschiene sichergestellt.

Ein weiterer großer Vorteil ist die Unabhängigkeit bei der Wahl des Materials für den Lagerblock. Während die Führungsschiene einstückig aus flexiblem preiswerten Kunststoff geformt sein kann, lässt sich für den Lagerblock ein wesentlich stabileres und widerstandsfähigeres Material wählen. Zweckmäßig ist der Lagerblock einschließlich des Verriegelungselements aus Metall gefertigt.

Das Verriegelungselement ist vorzugsweise als Verriegelungshöcker ausgebildet, welcher dem AMC-Standard entspricht. Wird der Lagerblock einschließlich des Verriegelungshöckers aus einem einzigen Stück Metall hergestellt, beispielsweise durch Druckguss oder Schmieden, so lässt sich ein normgerechter Verriegelungshöcker realisieren, der noch weitaus stabiler ist als es ein Verriegelungshöcker wäre, der integraler Bestandteil des Tragblechs ist.

In vorteilhafter Weiterbildung der Erfindung hat die Führungsschiene Befestigungsfüße, die in korrrespondierende Befestigungsausnehmungen des Tragblechs einsetzbar und durch Verschieben in Längsrichtung auf dem Tragblech befestigbar sind, und ist der Lagerblock in Längsrichtung verschieblich an der Führungsschiene gelagert. Die Befestigungsfüße haben vorzugsweise T-förmigen Querschnitt, so dass sie das Tragblech untergreifen können. Zur Montage wird die Führungsschiene zunächst von oben auf das Tragblech so aufgesetzt, dass zumindest einer der Befestigungsfüße in die korrespondierende Befestigungsausnehmung eintaucht. Gleichzeitig kann der Lagerzapfen des Lagerblocks in das zugehörige Formloch im Tragblech eingesetzt werden. Anschließend wird die Führungsschiene nach hinten verschoben. Die T-förmig ausgebildeten Befestigungsfüße untergreifen dann das Tragblech, so dass Führungsschiene und Tragblech fest miteinander verbunden sind. Die verschiebliche Lagerung des Lagerblocks an der Führungsschiene lässt eine Relativbewegung zwischen diesen beiden Teilen zu. Während die Führungsschiene ein Stück nach hinten gleitet, bleibt der Lagerblock unverändert in seiner Position, in der er durch den Lagerzapfen festgehalten wird. Am Ende ist nicht nur die Führungsschiene, sondern auch der Lagerblock durch Formschluss fest mit dem Tragblech verbunden.

Als Verbindung zwischen Führungsschiene und Lagerblock dient vorzugsweise ein an der Führungsschiene seitlich angeordnetes Gleitlager, in das ein Gleitsteg am Lagerblock eingreift. Ein derart ausgebildetes Gleitlager gewährleistet eine genaue Positionierung des Lagerblocks in zwei Achsen. Die auf das Verriegelungselement bzw. Verriegelungshöcker in Längsrichtung einwirkenden Kräfte werden von dem Lagerzapfen aufgenommen und in das Tragblech eingeleitet. Dabei kann der Lagerzapfen relativ groß und massiv ausgeführt werden, während für die Gleitschiene und die Gleitnut vergleichsweise geringe Abmessungen genügen, da sie ja nur geringe Kräfte übertragen müssen.

Eine besondere Ausführungsform des erfindungsgemäßen Baugruppenträgers wird nachstehend anhand der beigefügten Zeichnungen näher beschrieben. Es zeigen:

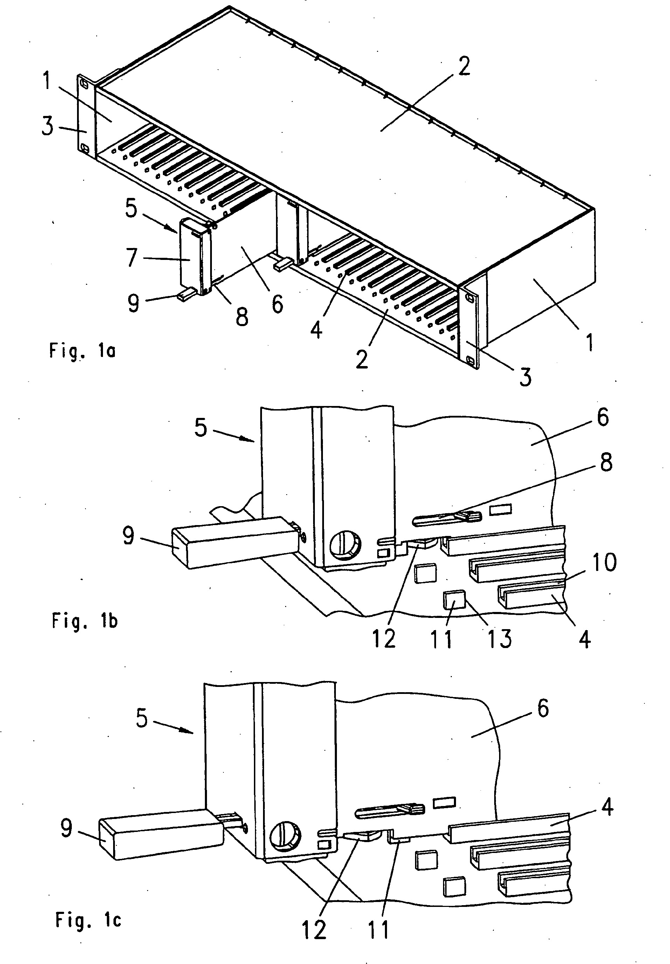

- Figur 1 a: einen Baugruppenträger mit zwei Steckbaugruppen, in einer stark vereinfachten perspektivischen Ansicht;
- Figur 1 b: einen Ausschnitt des Baugruppenträgers von Fig. 1 a mit einer vollständig eingeschobenen Steckbaugruppe, in vergrößertem Maßstab;
- Figur 1 c: die Steckbaugruppe gemäß Fig. 1b teilweise herausgezogen;
- Figur 2: ein einzelnes Tragblech und eine Führungsschiene mit Lagerblock;
- Figur 3a: das vordere Ende der Führungsschiene und den Lagerblock von Fig. 2, in vergrößertem Maßstab;
- Figur 3b: das vordere Ende der Führungsschiene mit aufgeschobenem Lagerblock;
- Figur 3c: einen Querschnitt entlang der Linie A-A in Fig. 3b;
- Figuren 4a - 4d: die Befestigung der Führungsschiene und des Lagerblocks auf dem Tragblech in drei Montageschritten, in drei perspektivischen Ansichten und einem Querschnitt;
- Figuren 5a - 5d: die drei Montageschritte in drei Längsschnitten.

Die Übersicht von Fig. 1 a zeigt einen Baugruppenträger mit zwei Seitenwänden 1 und zwei spiegelbildlich angeordneten Tragblechen 2, die seitlich durch die Seitenwände 1 in definiertem Abstand gehalten werden. Die Seitenwände 1 tragen rechts und links die typischen, nach außen abstehenden Befestigungsflansche 3, die es ermöglichen, den Baugruppenträger in ein Gestell oder ein Gehäuse einzubauen.

Auf dem unteren Tragblech 2 ist eine Anzahl von Führungsschienen 4 in regelmäßigem Abstand nebeneinander angeordnet. Gleichartige Führungsschienen 4 sind auch auf dem oberen Tragblech 2 jeweils gegenüberliegend angeordnet.

In Fig. 1a sind zwei Steckbaugruppen 5 zu sehen, von denen die rechte vollständig in den Baugruppenträger eingeschoben und die linke halb herausgezogen ist. Jede Steckbaugruppe 5 umfasst eine Leiterplatte 6 zur Aufnahme der elektronischen Elemente, eine an die Leiterplatte 6 montierte Frontplatte 7 und einen Verriegelungsmechanismus 8 mit einem nach vorne herausstehenden Verriegelungshebel 9.

Die vergrößerte Darstellung von Fig. 1b lässt erkennen, dass die Führungsschienen 4 eine nach oben offene Führungsnut 10 aufweisen, welche den Rand der Leiterplatte 6 der zugehörigen Steckbaugruppe 5 umgreift. Die Führungsnut 10 ist im Querschnitt U-förmig und ist zur Frontseite hin offen, so dass sich die Leiterplatte 6 ungehindert von vorne einschieben lässt.

Im Bereich der vorderen Kante des Tragblechs 2 sind kleine rechteckige Verriegelungshöcker 11 vorgesehen, die jeweils einer Führungsschiene 4 zugeordnet sind. Die Verriegelungshöcker 11 sind mit etwas Abstand und leicht seitlich versetzt in Bezug auf die Führungsnuten 10 angeordnet. Abmessungen und Positionen der Führungsnuten 10 und der Verriegelungshöcker 11 sind genormt und entsprechen beispielsweise den eingangs erwähnten Spezifikationen AMC und MicroTCA der PICMG.

Die Verriegelungshöcker 11 dienen der Verriegelung der vollständig eingeschobenen Steckbaugruppen 5. Hierzu weist der Verriegelungsmechanismus 8 eine Verriegelungszunge 12 auf, welche eine Verriegelungskante 13 des Verriegelungshöckers 11 umgreift. Durch Betätigung des Verriegelungshebels 9 lässt sich die Verriegelung lösen.

In Fig. 1c ist die Steckbaugruppe 5 ein kleines Stück nach vorne herausgezogen. Die Verriegelungszunge 12 findet sich nicht mehr in Eingriff mit dem Verriegelungshöcker 11.

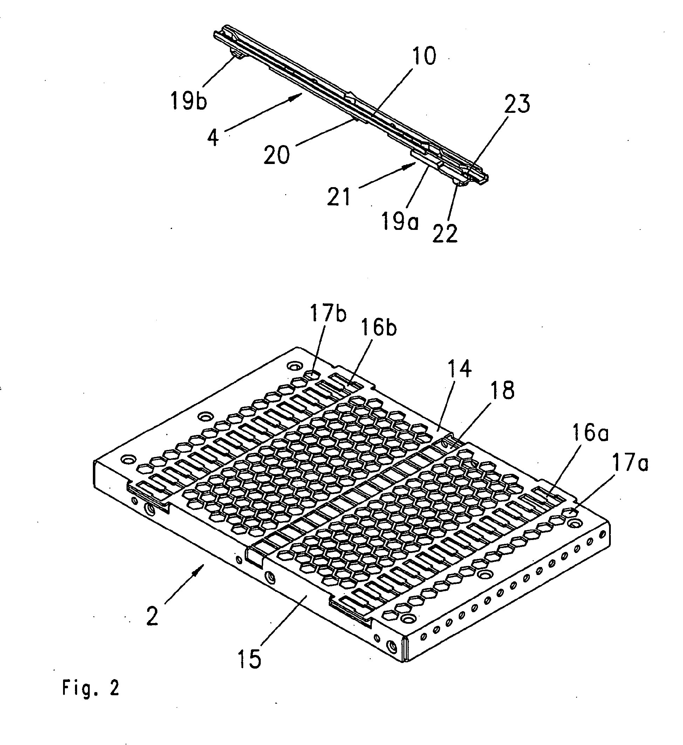

In Fig. 2 sind beispielhaft ein Tragblech 2 und eine darauf montierbare Führungsschiene 4 zu sehen.

Das Tragblech 2 besteht aus einem einzigen Stück Metall. Es hat eine ebene Oberseite 14 und seitliche Abkantungen 15. Aus der Oberseite 14 sind verschieden geformte Aussparungen ausgestanzt, die in einem vorgegebenen Raster angeordnet sind. Parallel zur vorderen Kante des Tragblechs 2 ist eine erste Reihe von vorderen Befestigungsausnehmungen 16a angeordnet. Im Bereich der hinteren Kante befindet sich eine zweite Reihe gleichartig ausgebildeter Befestigungsausnehmungen 16b. Die Befestigungsausnehmungen 16a und 16b haben eine Kontur, die aus zwei aneinander gesetzten Rechtecken mit abgestufter Breite gebildet wird. Den Befestigungsausnehmungen 16a, 16b sind jeweils Formlöcher 17a bzw. 17b zugeordnet. Diese haben die Kontur eines Sechsecks. Ungefähr in der Mitte des Tragblechs 2 ist zudem eine Reihe von äquidistanten Rastausnehmungen 18 mit rechteckiger Kontur angeordnet.

Die Führungsschiene 4 trägt an ihrer Unterseite jeweils einen vorderen Befestigungsfuß 19a und einen hinteren Befestigungsfuß 19b, welche in die vorderen Befestigungsausnehmungen 16a bzw. die hinteren Befestigungsausnehmungen 16b des Tragblechs 2 eingesetzt werden können. Etwa in der Mitte der Führungsschiene 4 ist ein kleiner Rasthaken 20 ausgebildet, welche in eine Rastausnehmung 18 einschnappen kann. Die Führungsschiene 4 ist einstückig aus einem Kunststoff gefertigt, der relativ hart, gleichzeitig aber elastisch und ausreichend bruchsicher ist, so dass die Führungsschiene 4 etwas nach oben gebogen werden kann.

Am vorderen Ende der Führungsschiene 4 ist ein schmaler Lagerblock 21 verschieblich gelagert. Dieser Lagerblock 21 weist an seiner Unterseite einen im Querschnitt sechseckigen Lagerzapfen 22 aus, der formschlüssig in ein sechseckiges Formloch 17a des Tragblechs 2 passt. An seiner Oberseite trägt der Lagerblock 21 einen Verriegelungshöcker 23, der in Form und Abmessungen den in den Figuren 1a, 1b und 1c dargestellten Verriegelungshöckern 11 entspricht.

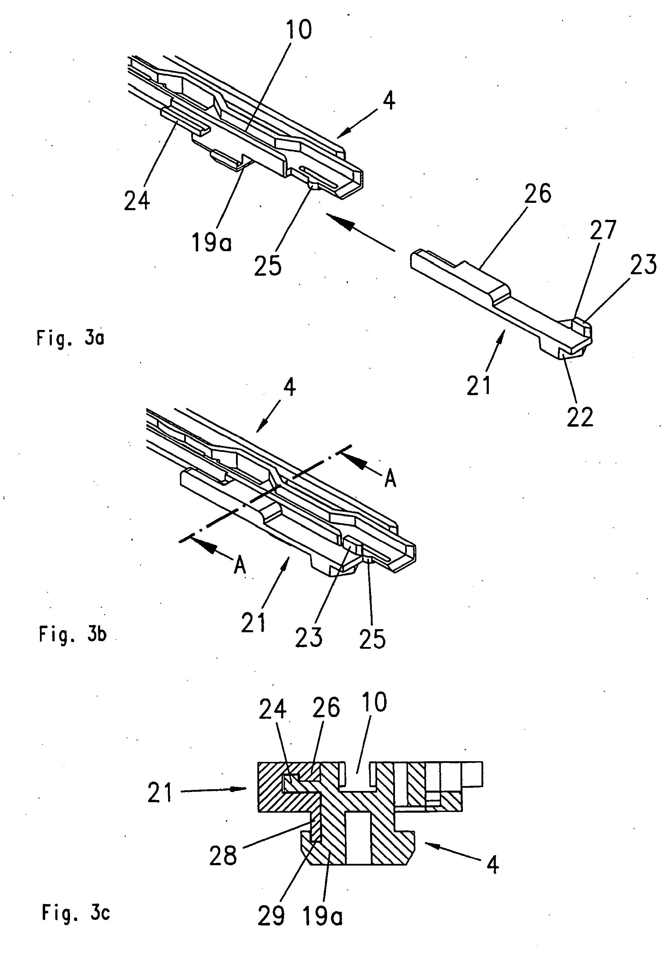

Fig. 3a zeigt das vordere Ende der Führungsschiene 4 und den Lagerblock 21 im Detail. Zu sehen ist die nach oben offene Führungsnut 10 für die Leiterplatte 6 (vgl. Fig. 1a, 1b). An der Unterseite befindet sich der vordere Befestigungsfuß 19a, der im Querschnitt T-förmig ausgebildet ist. An der - von vorne gesehen - linken Seite der Führungsschiene 4 ist ein im Querschnitt L-förmiges Gleitlager 24 für den Lagerblock 21 angeformt. Ganz vorne ist eine kleine halbrunde Rastnase 25 ausgebildet. Der Lagerblock 21 hat einen seitlichen Gleitsteg 26, mit dem er in Pfeilrichtung auf das Gleitlager 24 der Führungsschiene 4 aufschiebbar ist. Der Verriegelungshöcker 23 hat eine nach hinten weisende Verriegelungskante 27 für den Eingriff einer Verriegelungszunge 12 (vgl. Fig. 1b, 1c).

In Fig. 3b ist der Lagerblock so weit auf die Führungsschiene 4 aufgeschoben, dass die zugespitzte vordere Kante des Verriegelungshöckers 23 hinter die Rastnase 25 eingeschnappt ist. Dadurch wird verhindert, dass der Lagerblock 21 versehentlich von der Führungsschiene 4 rutscht.

Im Schnittbild von Fig. 3c ist zu erkennen, wie der Lagerblock 21 auf der Führungsschiene 4 in Längsrichtung verschieblich gelagert ist. Der Gleitsteg 26 des Lagerblocks 21 sitzt auf dem seitlich an der Führungsschiene 4 angeformten Gleitlager 24, das L-förmigen Querschnitt hat. Der Lagerblock 21 trägt an seiner Unterseite ferner einen schmalen Gleitfuß 28 für den Eingriff in eine nach oben offene Gleitnut 29, die am vorderen Befestigungsfuß 19a der Führungsschiene 4 ausgebildet ist (vgl. Fig. 3a).

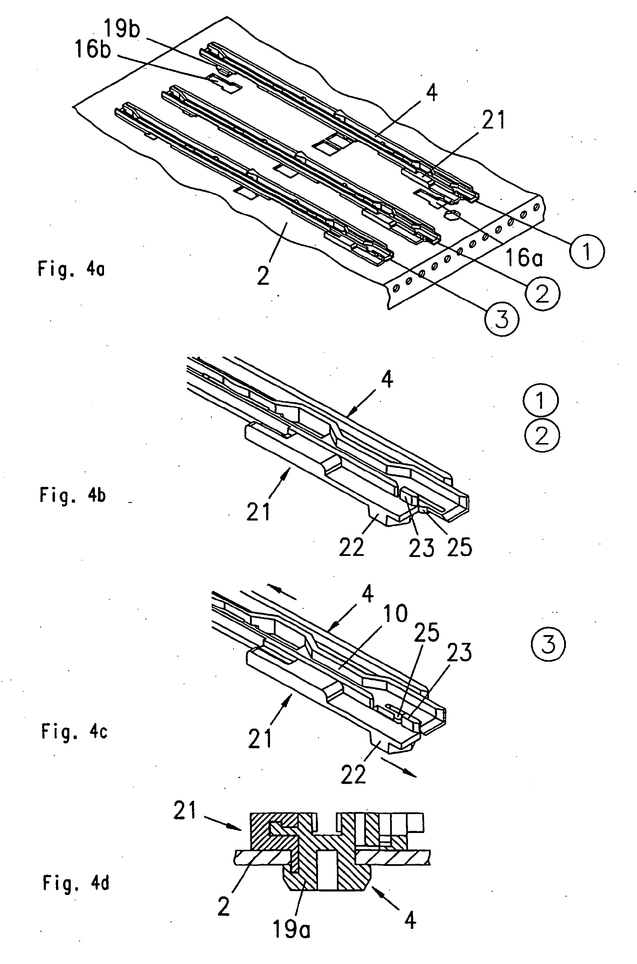

Anhand der Figuren 4a bis 4d wird nun erläutert, wie eine Führungsschiene mit vormontiertem Lagerblock in drei Schritten auf einem Tragblech befestigt wird:

In Fig. 4a ist eine Führungsschiene 4 mit vorne aufgeschobenem Lagerblock 21 in drei verschiedenen Zuständen zu sehen. Im Zustand (1) hat die Führungsschiene 4 noch keinen Kontakt mit dem Tragblech 2. Der Lagerblock 21 ist auf das vordere Ende der Führungsschiene 4 aufgeschoben und befindet sich in einer in Einschubrichtung ganz nach hinten geschobenen Lage. Dabei befindet sich der Verriegelungshöcker 23 hinter der Rastnase 25, wie in Fig. 4b zu sehen ist.

Im nächsten Schritt werden nun die Führungsschiene 4 und der Lagerblock 21 gemeinsam in das Tragblech 2 eingesetzt, wobei zuerst der hintere Befestigungsfuß 19b in eine hintere Befestigungsausnehmung 16b eintaucht, bevor der vordere Befestigungsfuß 19a in eine vordere Befestigungsausnehmung 16a eingesetzt wird. Gleichzeitig taucht der Lagerzapfen 22 des Lagerblocks 21 in das der vorderen Befestigungsausnehmung 16a zugeordnete Formloch 17a ein. Dieser Zustand (2) ist in der Mitte der Fig. 4a dargestellt.

Die Montage wird dadurch abgeschlossen, dass die eingesetzte Führungsschiene 4 in Längsrichtung nach hinten geschoben wird. Dieser Zustand (3) ist in Fig. 4a links dargestellt. Dadurch rutschen die Befestigungsfüße 19a und 19b in den Befestigungsausnehmungen 16a, 16b soweit nach hinten, bis sie an den jeweils hinteren Kanten der Befestigungsausnehmungen 16a, 16b anschlagen. Die T-förmig ausgebildeten Befestigungsfüße 19a, 19b untergreifen jetzt das Tragblech 2, wie das am besten im Schnittbild von Fig. 4d zu sehen ist. Der Lagerzapfen 22 sitzt formschlüssig im Formloch 17a und hält den Lagerblock 21 in seiner einmal gefundenen Lage auf dem Tragblech 2 fest. Da der Lagerblock 21, wie beschrieben, in Längsrichtung verschieblich an der Führungsschiene 4 gelagert ist, kommt es zu einer Relativbewegung zwischen Führungsschiene 4 und Lagerblock 21. Dies ist in Fig. 4c durch zwei gegenläufige Pfeile angedeutet. Ein Vergleich der Figuren 4b und 4c verdeutlicht die veränderte Relativlage vor (Fig. 4b) und nach (Fig. 4c) dem Verschieben der Führungsschiene 4 nach hinten. In Fig. 4c befindet sich der Verriegelungshöcker 23 jetzt vor der Rastnase 25 und damit in der durch die Norm vorgeschriebenen Position in definiertem Abstand vor dem Anfang der Führungsnut 10.

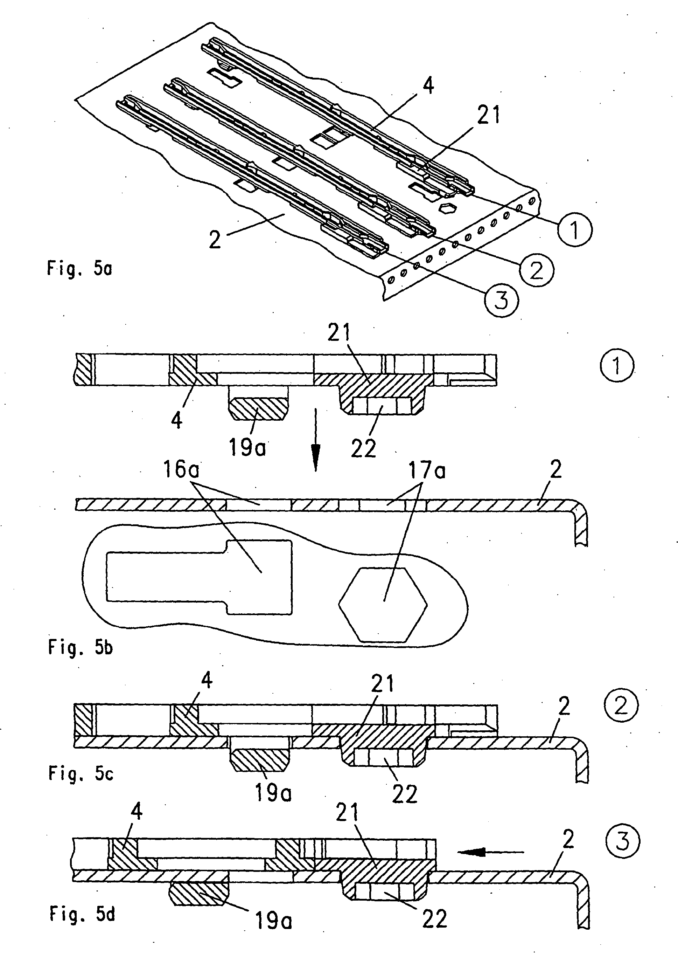

Die Längsschnitte der Figuren 5b, 5c und 5d zeigen nochmals die unterschiedlichen Positionen der Führungsschiene 4 und des Lagerblocks 21 zueinander und in Bezug auf das Tragblech 2 bei den Montageschritten (1), (2) und (3).

In Fig. 5b befindet sich die Führungsschiene 4 mit dem anmontierten Lagerblock 21 noch über dem Tragblech 2. Der Lagerblock 21 ist auf der Führungsschiene 4 ganz nach hinten - in der Zeichnung links - geschoben. Der vordere Befestigungsfuß 19a der Führungsschiene 4 und der Lagerzapfen 22 des Lagerblocks 21 sind nahe beieinander. Führungsschiene 4 und Lagerblock 21 sind bereits so ausgerichtet, dass der Befestigungsfuß 19a mit der Befestigungsausnehmung 16a und der Lagerzapfen 22 mit dem zugeordneten Formloch 17a fluchtet.

In Fig. 5c sitzen die Führungsschiene 4 und der Lagerblock 21 auf der Oberseite des Tragblechs 2 auf. Der Befestigungsfuß 19a greift in die Befestigungsausnehmung 16a ein. Der Lagerzapfen 22 sitzt bereits in seiner endgültigen Lage im Formloch 17a.

In Fig. 5d ist die Führungsschiene in Pfeilrichtung - in der Zeichnung nach links - verschoben. Der Lagerblock 21 mit seinem Lagerzapfen 22 hat seine Position auf dem Tragblech 2 beibehalten. In Folge der Relativbewegung zwischen Führungsschiene 4 und Lagerblock 21 hat sich der Befestigungsfuß 19a der Führungsschiene 4 vom Lagerzapfen 22 entfernt. Der Befestigungsfuß 19a untergreift jetzt das Tragblech 2 im Bereich des hinteren Rechtecks der Befestigungsausnehmung 16a.

### Liste der Bezugszeichen

- 1: Seitenwand
- 2: Tragblech
- 3: Befestigungsflansch
- 4: Führungsschiene
- 5: Steckbaugruppe
- 6: Leiterplatte
- 7: Frontplatte
- 8: Verriegelungsmechanismus
- 9: Verriegelungshebel
- 10: Führungsnut (von 4)
- 11: Verriegelungshöcker (an 2)
- 12: Verriegelungszunge (von 8)
- 13: Verriegelungskante (von 11)
- 14: Oberseite (von 2)
- 15: Abkantung
- 16a: (vordere) Befestigungsausnehmung
- 16b: (hintere) Befestigungsausnehmung
- 17a: (vorderes) Formloch
- 17b: (hinteres) Formloch
- 18: Rastausnehmung
- 19a: (vorderer) Befestigungsfuß
- 19b: (hinterer) Befestigungsfuß
- 20: Rasthaken
- 21: Lagerblock
- 22: Lagerzapfen
- 23: Verriegelungshöcker (von 21)
- 24: Gleitlager
- 25: Rastnase
- 26: Gleitsteg
- 27: Verriegelungskante (von 23)
- 28: Gleitfuß
- 29: Gleitnut

## Patentansprüche

1. Baugruppenträger für elektronische Steckbaugruppen, die eine Leiterplatte, eine Frontplatte und einen Steckverbinder aufweisen, mit
- wenigstens einem Tragblech, das im Raster angeordnete Befestigungsausnehmungen aufweist,
- mindestens einer Führungsschiene aus einem Kunststoff, die auf das Tragblech montierbar ist und eine nach oben offene Führungsnut aufweist,
- ein im Bereich der vorderen Kante des Tragblechs angeordnetes Verriegelungselement (23), das der Verriegelung der vollständig eingeschobenen Steckbaugruppe dient, einem separaten Lagerblock (21), der
- an der Führungsschiene (4) gelagert ist,
- einen Lagerzapfen (22) hat, der formschlüssig in ein Formloch (17a) des Tragblechs (2) einsetzbar ist,
- das Verriegelungselement (23) trägt,
**dadurch gekennzeichnet, dass** der Lagerblock (21) einschließlich des Verriegelungselements (23) aus einem stabileren und widerstandsfähigeren Material als die Führungsschiene (24), vorzugsweise aus Metall, gefertigt ist.

2. Baugruppenträger nach Anspruch 1, **dadurch gekennzeichnet, dass** das Verriegelungselement als Verriegelungshöcker (23) mit einer Verriegelungskante (27) ausgebildet ist.

3. Baugruppenträger nach Anspruch 1 oder 2, **dadurch gekennzeichnet, dass**
- die Führungsschiene (4) an ihrer Unterseite Befestigungsfüße (19a, 19b) hat, die in korrespondierende Befestigungsausnehmungen (16a, 16b) einsetzbar und durch Verschieben in Längsrichtung mit dem Tragblech (2) formschlüssig verbindbar sind,
- der Lagerblock (21) in Längsrichtung verschieblich an der Führungsschiene (4) gelagert ist.

4. Baugruppenträger nach Anspruch 3, **dadurch gekennzeichnet, dass** die Befestigungsfüße (19a, 19b) im Querschnitt T-förmig ausgebildet sind, um das Tragblech (2) zu untergreifen.

5. Baugruppenträger nach einem der Ansprüche 1 bis 4, **dadurch gekennzeichnet, dass**
- seitlich an der Führungsschiene (4) ein Gleitlager (24) vorgesehen ist,
- der Lagerblock (21) einen Gleitsteg (26) aufweist, der in dem Gleitlager (24) geführt ist.

6. Baugruppenträger nach einem der Ansprüche 1 bis 5, **dadurch gekennzeichnet, dass** der Lagerblock (21) einstückig aus Metall gefertigt ist.

## Claims

1. A rack for electronic plug-in units, which have a printed circuit board, a front plate and a plug connector, including
- at least one support plate, which has fastening openings arranged in a pattern,
- at least one guide track of a plastic material, which may be mounted on the support plate and has an upwardly open guide groove
- a locking element (23), which is arranged in the region of the front edge of the support plate and which serves to lock the fully inserted plug-in unit
- a separate bearing block (21), which
- is mounted on the guide track (4),
- has a bearing peg (22), which is insertable in a form-locking manner into a shaped hole (17a) in the support plate (2),
- carries the locking element (23),
- **characterised in that** the bearing block (21) including the locking element (23) is made of a more stable and more resistant material than the guide track (24), preferably of metal.

2. A rack as claimed in Claim 1, **characterised in that** the locking element is constructed in the form of a locking protuberance (23) with a locking edge (27).

3. A rack as claimed in Claim 1 or 2, **characterised in that**
- the guide track (4) has on its underside fastening feet, (19a, 19b), which are insertable into corresponding fastening openings (16a, 16b) and are positively connectable to the support plate (2) by sliding in the longitudinal direction.
- the bearing block (21) is mounted so as to be movable in the longitudinal direction on the guide track (4).

4. A rack as claimed in Claim 3, **characterised in that** the fastening feet, (19a, 19b) are of T-shape in cross section in order to engage beneath the support plate (2).

5. A rack as claimed in one of Claims 1 to 4, **characterised in that**
- provided laterally on the guide track (4) there is a sliding bearing (24)
- the bearing block (21) has a sliding web (26), which is guided in the sliding bearing (24).

6. A rack as claimed in Claims to 5, **characterised in that** the bearing block (21) is made in one piece of metal.

## Revendications

1. Support de modules pour des modules à fiches électroniques qui présentent une carte imprimée, une plaque avant et un connecteur à fiches, comprenant
- au moins une tôle support qui présente des évidements de fixation disposés en trame,
- au moins un rail de guidage en matière plastique qui peut être monté sur la tôle support et présente une rainure de guidage ouverte vers le haut,
- un élément de verrouillage (23) qui est disposé dans la zone de l'arête avant de la tôle support et sert à verrouiller le module à fiches totalement inséré,
- un bloc palier (21) séparé qui
- est monté sur le rail de guidage (4),
- présente un tourillon (22) pouvant être mis en place par coopération de forme dans un trou de forme (17a) de la tôle support (2),
- supporte l'élément de verrouillage (23),
**caractérisé en ce que** le bloc palier (21), y compris l'élément de verrouillage (23), est fabriqué en un matériau plus stable et plus résistant que le rail de guidage (24), de préférence en métal.

2. Support de modules pour des modules électroniques suivant la revendication 1, **caractérisé en ce que** l'élément de verrouillage est réalisé en forme de protubérance de verrouillage (23) avec une arête de verrouillage (27).

3. Support de modules pour des modules électroniques suivant l'une des revendications 1 et 2, **caractérisé en ce que**
- le rail de guidage (4) présente sur sa face inférieure des pieds de fixation (19a, 19b) qui peuvent être mis en place dans des évidements de fixation correspondants (16a, 16b) et être reliés avec coopération de forme avec la tôle support (2) par déplacement dans la direction longitudinale,
- le bloc palier (21) est monté sur le rail de guidage (4) de manière mobile dans la direction longitudinale.

4. Support de modules pour des modules électroniques suivant la revendication 3, **caractérisé en ce que** les pieds de fixation (19a, 19b) sont réalisés en forme de T en section transversale pour enserrer la tôle support (2).

5. Support de modules pour des modules électroniques suivant l'une des revendications 1 à 4, **caractérisé en ce que**
- un palier lisse (24) est prévu latéralement sur le rail de guidage (4),
- le bloc palier (21) présente une traverse de glissement (26) qui est guidée dans le palier lisse (24).

6. Support de modules pour des modules électroniques suivant l'une des revendications 1 à 5, **caractérisé en ce que** le bloc palier (21) est fabriqué d'un seul tenant et en métal.
